# EUROPÄISCHE PATENTANMELDUNG

(11) **EP 0 666 552 A2**
(43) Veröffentlichungstag der Anmeldung: **09.08.1995**
(21) Anmeldenummer: 94118353.5
(22) Anmeldetag: 22.11.1994
(51) Int. Cl.: G09B 21/00, G01R 1/073

(54) **Vorrichtung zur Erzeugung von durch Höhenunterschiede charakterisierten Betriebszuständen mechanischer Stellglieder**

(30) Priorität: 08.02.1994 DE 4403831
(71) Anmelder: PTS Gesellschaft für Physikalisch-Technische Studien Jena mbH, D-07745 Jena (DE)
(72) Erfinder: Hornhauer, Henry, D-07747 Jena (DE); Weinholdt, Michael, D-07743 Jena (DE)
(74) Vertreter: Geyer, Werner, Dr.-Ing.

(57) **Zusammenfassung**

Die Erfindung betrifft eine Vorrichtung zur Erzeugung von durch Höhenunterschiede charakterisierten Betriebszuständen matrixförmig angeordneter Stellglieder (1).
Die Aufgabe, eine einfache Möglichkeit zur Erzeugung von durch Höhenunterschiede charakterisierten Betriebszuständen bei in enger matrixförmiger Anordnung beliebig und unabhängig voneinander steuerbaren mechanischen Stellgliedern (1) zu finden, wird in einer entsprechenden Vorrichtung gelöst, indem ein mit elektroviskoser Flüssigkeit gefülltes Reservoir (2) eine Überdruck- (21) und eine Unterdruckkammer (22) besitzt und diese Kammern jeweils über separate Steuerkanäle (16) mit den Hydrozylindern (12) der Stellglieder (1) verbunden sind, wobei durch die zwei Steuerkanäle (16) eines Stellgliedes (1) über eine erste bzw. zweite Elektrode (17, 18) und eine gemeinsame, steuerbare Mittelelektrode (19) alternativ die Verbindung zu den zwei Kammern des Reservoirs (2) herstellt oder unterbindet. Die so entstehende Druckvariation ändert über eine Elastomermembran (13) die Höheneinstellung eines mechanischen Stiftes (11).
Die Erfindung findet vorwiegend Anwendung für adaptive Leiterplattentester und zur Darstellung von Blindenschrift.

## Beschreibung

Die Erfindung betrifft eine Vorrichtung zur Erzeugung von durch Höhenunterschiede charakterisierten Betriebszuständen mechanischer Stellglieder, wie sie vorzugsweise für die tastbare Darstellung der Braille-Schrift und für Adapter von Leiterplattentestern angewendet werden.

Mechanisch höhenverstellbare Stellglieder werden vielfach matrixförmig angeordnet in der Technik angewendet, um verschiedene Betriebszustande zu realisieren.
So sind z. B. Adapter für Leiterplattentester bekannt, bei denen in einem matrixförmigen Raster Kontaktnadeln entsprechend der vorgesehenen Meßaufgabe jeweils manuell oder durch spezifische Handlingtechnik gesteckt werden. Damit ist z. T. ein hoher Zeitaufwand verbunden bzw. die Anwendung aufvorhandene Adapter beschränkt.
Andere Vorrichtungen zur Erzeugung von höhenverschiedenen Stellgliedern, die beliebig steuerbar sein müssen, sind für die Darstellung der Braille-Schrift, insbesondere bei Computer- und Schreibmaschinenanzeigemodulen, bekannt.
Dabei gibt es prinzipiell zwei verschiedene Realisierungen.
Zum einen finden piezoelektrische Biegeelemente zur Höhenverstellung Anwendung, die durch ihre notwendige Baugröße auf Zeilenanordnungen beschränkt sind.
Andererseits sind Hydrauliksysteme bekannt geworden, die Matrixanordnungen realisieren und mit elektroviskosen Flüssigkeiten betrieben werden. Ein Beispiel für solche Vorrichtungen ist in der DE-OS 40 07 945 offenbart. Hier werden die Anzeigeelemente durch hydraulisch verstellbare Hubelemente verkörpert und derart betrieben, daß der Flüssigkeit in einem Vorratsbehälter periodische Druckänderungen geeigneter Frequenz so aufgeprägt werden, daß der Druckverlauf an allen Steuerkanälen nur geringe Phasendifferenzen aufweist. Mit der gleichen Frequenz, mit der die Druckänderungen erfolgen, wird eine Stellelektrode in jedem Steuerkanal mit einer Gleichspannung beschaltet. Die Größe des Phasenwinkels zwischen Druckänderungen und Spannungsimpulsen regelt dabei die Füllmenge im Arbeitsraum des Anzeigeelements und damit den tastbaren Gegendruck des Anzeigeelements.

Nachteilig daran ist, daß lediglich kleine Stellwege und geringe Druckunterschiede erzeugt werden können. Weiterhin ist eine Umwälzung der elektroviskosen Flüssigkeit nicht möglich, wodurch Entmischungsprozesse begünstigt werden.
Der Erfindung liegt deshalb die Aufgabe zugrunde, eine Möglichkeit zur Erzeugung von durch Höhenunterschiede charakterisierten Betriebszuständen mechanischer Stellglieder zu finden, die mit einfachen Mitteln Hubbewegungen der Stellglieder in enger matrixförmiger Anordnung beliebig und unabhängig voneinander realisiert. Außerdem soll eine Entmischung der Flüssigkeit verhindert werden.

Erfindungsgemäß wird die Aufgabe bei einer Vorrichtung zur Erzeugung von durch Höhenunterschiede charakterisierten Betriebszuständen mechanischer Stellglieder, die hydraulisch verstellbar sind, mit einer elektroviskosen Flüssigkeit betrieben werden und mit Elektroden versehene Steuerkanäle, die je nach anliegender Spannung das Strömen der Flüssigkeit zulassen oder unterbinden, aufweisen, dadurch gelöst, daß jedes Stellglied einen Hydrozylinder enthält, der über zwei Steuerkanäle mit einem Reservoir in Verbindung steht, daß sich das Reservoir aus einer Überdruck- und einer Unterdruckkammer zusammensetzt, daß einer der Steuerkanäle mit der Überdruckkammer und der andere mit der Unterdruckkammer verbunden ist und daß die Steuerkanäle eines Stellgliedes jeweils eine erste Elektrode bzw. eine zweite Elektrode, die im Betriebszustand auf unterschiedliche Potentiale festgelegt sind, sowie eine gemeinsame Mittelelektrode aufweisen, wobei die Mittelelektrode die einzige Steuerelektrode eines jeden Stellgliedes darstellt und im Umfang der Potentialdifferenz zwischen der ersten und zweiten Elektrode umschaltbar ist, so daß der Durchfluß je nach Potentialunterschied in einem Steuerkanal ermöglicht und im anderen behindert wird.
Die Hydrozylinder bestehen vorzugsweise aus einer Elastomermembran.
Zweckmäßig lassen sich mehrere Hydrozylinder zu einem Modul (z.B. 8er-Modul für Braille-Schrift) zusammenfassen.
Sämtliche Hydrozylinder werden vorteilhaft als zweidimensionale Matrix auf dem einheitlichen Reservoir angeordnet.
Es erweist sich von Vorteil, das notwendige Druckgefälle zwischen Überdruckkammer und Unterdruckkammer durch eine Pumpe zu erzeugen. Dazu eignet sich insbesondere eine Zahnradpumpe. Weiterhin verfügen beide Kammern zweckmäßig über Gaspolster, die als Puffer zur Druckregulierung dienen.

Die ersten und zweiten Elektroden unterschiedlicher Stellglieder sind bei der Zusammensetzung von Modulen und Matrixanordnungen vorteilhaft jeweils untereinander verbunden, wobei die eine Gruppe von Elektroden auf Bezugspotential und die andere Gruppe auf Betriebsspannung gelegt wird und die Mittelelektrode wahlweise auf eines der Potentiale der beiden Gruppen umschaltbar ist.
Es erweist sich als vorteilhaft, sämtliche Elektroden von Stellgliedern über eine Anlaufregimesteuerung zu führen, die neben der Einstellung des notwendigen Druckgefälles zwischen Über- und Unterdruckkammer gewährleistet, daß alle Elektroden mindestens modulweise auf gleiches Potential umschaltbar sind zum Durchspülen der betreffenden Hydrozylinder in einer Anlaufphase. Diese Anlaufregimesteuerung wird zweckmäßig auch während längerer Betriebspausen zyklisch aktiviert, um Entmischungsvorgängen der elektroviskosen Flüssigkeit entgegenzuwirken.
Die Erfindung basiert auf der Überlegung, daß es zur Realisierung von Matrixanordnungen mit engem Rasterabstand und deutlichem Unterschied zwischen den Betriebszuständen der Steliglieder erforderlich ist, eine Vorrichtung zu konstruieren, deren Stellglieder sich durch geringen lateralen Raumbedarf, einfache Ansteuerung und relativ große Stellwege auszeichnen. Die einfache Ansteuerung bei Verwendung elektroviskoser Flüssigkeiten bietet dazu die notwendige Voraussetzung. Dabei laßt sich erfindungsgemäß zur Höhenverstellung der Stellglieder abwechselnd eine Über- oder Unterdruckkammer mit den Hydrozylindern der Stellglieder in Verbindung bringen. Diese umschaltbare Verbindung zur Erzeugung von Druckunterschieden in den Hydrozylindern wird durch zwei alternative durchlässige Steuerkanäle mittels zweier Elektroden auf unterschiedlichem Konstantpotential und einer steuerbaren Mittelelektrode realisiert, die zwischen den beiden Konstantpotentialen regelbar ist. Durch die damit vorhandenen separaten Ein- und Auslaßventile wird eine Flüssigkeitszirkulation erreicht, die einfach steuerbar ist und eine vollständige Umwälzung der elektroviskosen Flüssigkeit zur Folge hat.
Mit der erfindungsgemaßen Vorrichtung ist es möglich, Höhenunterschiede an mechanischen Stellgliedern enger matrixförmiger Anordnung beliebig und unabhängig voneinander mit einfachen Mitteln zu erzeugen, wobei relativ große Druckunterschiede und Stellwege realisiert werden. Außerdem gestattet das Prinzip von durchströmten Hydrozylindern, eine vollständige Umwälzung der elektroviskosen Flüssigkeit, wodurch Entmischungserscheinungen der Flüssigkeitsbestandteile entgegengewirkt wird.

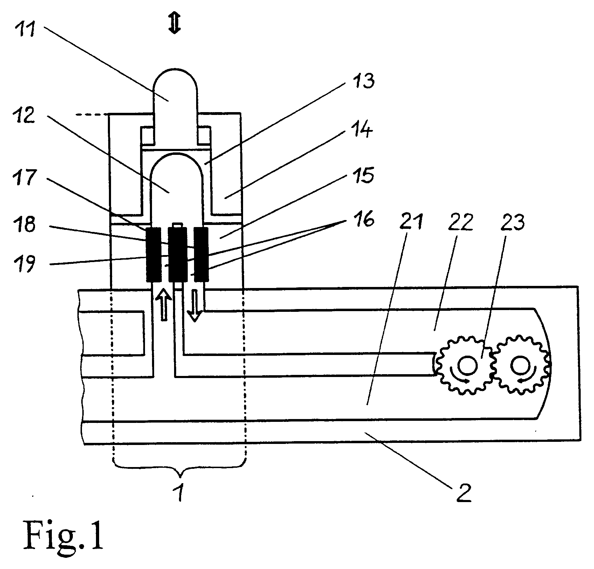

Die Erfindung soll nachstehend anhand von Ausführungsbeispielen näher erläutert werden. Die Zeichnungen zeigen:
- Fig.1: das Prinzipschema der erfindungsgemäßen Vorrichtung mit einem Stellglied 1
- Fig.2: das Elektroden- und Schaltschema anhand von einem dreigliedrigen Modul
Die erfindungsgemäße Vorrichtung besteht in ihrem Grundaufbau - wie in Fig. 1 schematisch dargestellt - aus Stellgliedern 1, die jeweils einen mittels Volumenänderung eines Hydrozylinders 12 mechanisch höhenverstellbaren Stift 11 enthalten, und einem Reservoir 2 mit einer Ûberdruckkammer 21 und einer Unterdruckkammer 22, die jeweils über einen von zwei Steuerkanälen 16 eines Stellgliedes 1 mit dessen Hydrozylinder 12 in Verbindung stehen. Als Betriebsmedium wird eine elektroviskose Flüssigkeit verwendet. Die erfindungsgemäßen Stellglieder 1, von denen Fig. 1 lediglich eins repräsentativ Zeigt, sind zweckmäßig in Modulbauweise auf dem als Träger dienenden Reservoir 2 zusammengefaßt. Dabei bilden die Module 3 zusammen eine Matrix, wobei die Module 3 sowohl Zeilen- als auch Flächengebilde sein können (z.B. Zeilenmodule für Leiterplatten, 8gliedriges Brailleelement).

Jedes Stellglied 1 besteht aus einer Sockelplatte 15, in der zwei (vorzugsweise rechteckige) Steuerkanäle zum Reservoir 2 eingelassen sind, einer den Hydrozylinder 12 umgebenden Elastomermembran 13, die an ihrer Oberseite den Stift 11 trägt, und einer Abdeckplatte 14. Die Steuerkanäle 16 besitzen jeweils eine Konstantpotential-Elektrode sowie eine gemeinsame Mittelelektrode 19 als Steuerelektrode, woraus sich zweckmäßig eine parallele Lage zueinander ergibt. Die Konstantpotential-Elektroden liegen auf unterschiedlichem Potential und werden deshalb im folgenden als erste Elektrode 17 und zweite Elektrode 18 je Stellglied 1 bezeichnet. Die erste Elektrode 17 ist beispielsweise auf Bezugspotential und die zweite Elektrode 18 auf Betriebsspannung gelegt. Die Mittelelektrode 19 wird in ihrem Potential zwischen diesen beiden Potentialen verändert. Im einfachsten Fall wird sie wahlweise auf eines der zwei Potentiale umgeschaltet. Dadurch entsteht jeweils in nur einem Steuerkanal ein elektrisches Feld zur Behinderung des Durchflusses. Eine Pumpe zwischen Überdruckkammer 21 und Unterdruckkammer 22 sorgt für das im Betriebszustand notwendige permanente Druckgefälle zwischen beiden Kammern. Dazu eignet sich beispielsweise eine Zahnradpumpe 23, wie sie in Fig. 1 schematisch dargestellt ist. Diese Aufgabe kann jedoch auch durch jede beliebige Flüssigkeitspumpe erfüllt werden, wie zum Beispiel Kreiselpumpe, Membranpumpe o.ä.

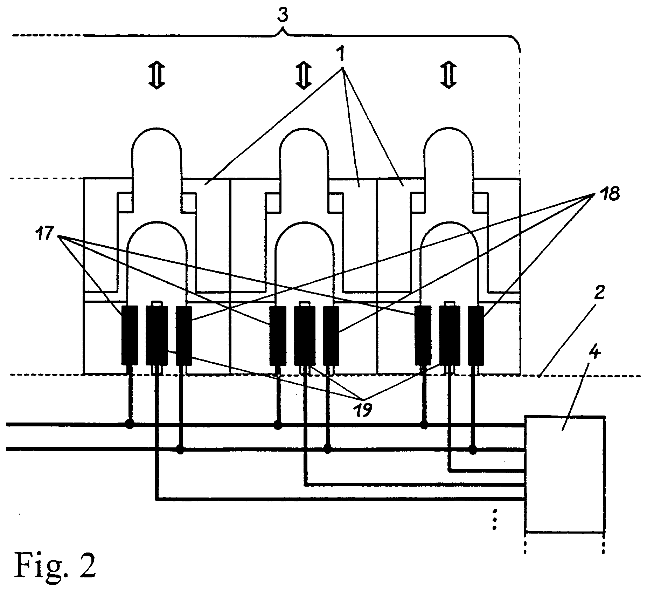

Auf diesem konstruktiven Aufbau basiert die folgende Funktionsweise.
Mit der Inbetriebnahme läuft die Zahnradpumpe 23 an und sorgt für einen Druckunterschied zwischen Über- und Unterdruckkammer 21 bzw. 22. Dieses Druckgefälle wird vorteilhaft durch entsprechende Gaspolster in den zwei Kammern gepuffert. Bei der angegebenen Beschaltung von erster Elektrode 17 und zweiter Elektrode 18 sowie der Annahme, daß die Mittelelektrode 19 auf dem gleichen Potential wie die erste Elektrode 17 liegt, strömt die elektroviskose Flüssigkeit durch den linken Steuerkanal 16 des in Fig. 1 dargestellten Stellgliedes 1. Im rechten Steuerkanal 16 wird durch den Potentialunterschied zwischen Mittelelektrode 19 und zweiter Elektrode 18 die elektroviskose Flüssigkeit in ihrer Fließfähigkeit behindert, d.h. ihre Viskosität wird soweit erhöht, daß sie nahezu erstarrt. Somit baut sich im Hydrozylinder 12 des Stellgliedes 1 der gleiche Druck wie in der Überdruckkammer 21 auf, und durch Dehnung der Elastomermembran wird der Stift 11 in seinen zweckbedingten oberen Betriebszustand ausgeschoben.
Wird anschließend die Mittelelektrode 19 auf das Potential der zweiten Elektrode umgepolt, führt dieser Vorgang Zur Sperrung des linken und Öffnung des rechten Steuerkanals 16. Durch die freigegebene Verbindung zur Unterdruckkammer 22 findet mit dieser ein Druckausgleich statt. Der resultierende Unterdruck zieht die Rückstellung des Stiftes 11 innerhalb der Führung der Abdeckplatte 14 nach sich. Für den Aufbau einer ganzen Matrix von Stellgliedern 1 ist es vorwiegend aus Kostengründen (aber auch aus funktionellen Erwägungen) sinnvoll, die Stellglieder 1 zu Modulen 3 zusammenzufassen. Entsprechend sind dann mindestens die ersten bzw. die zweiten Elektroden 17 bzw. 18 der Stellglieder 1 eines Moduls 3 miteinander verbunden, wie es Fig. 2 zeigt. Es ist aber auch vielfach zweckmäßig, mehrere Module 3 schaltungsmäßig auf sammelleitungen zu verknüpfen.
Zur Verhinderung der Entmischung der elektroviskosen Flüssigkeit wird diese kontinuierlich umgewälzt. Das geschieht im normalen Betrieb durch die zeitverzögerte Durchströmung jedes Stellgliedes 1 bei einem Ansteuerungswechsel der Mittelelektrode 19. Bei Inbetriebnahme nach einer Betriebspause oder aber innerhalb längerer Betriebspausen macht es sich erforderlich, die Hydrozylinder 12 aller Stellglieder 1 durchzuspülen. Damit ein kräftiger Spüleffekt auch innerhalb größerer matrixförmiger Anordnungen von Stellgliedern 1 erzeugt wird, werden die Stellglieder 1 mittels einer (in Fig. 2 nur schematisch dargestellten) Anlaufregimesteuerung 4 aufeinanderfolgend modulweise oder unter Zusammenfassung mehrerer Module 3 elektrisch kurzgeschlossen, d.h. alle Elektroden 17, 18 und 19 einer ausgewählten Gruppe von Stellgliedern 1 oder Modulen 3 werden innerhalb der Anlaufregimesteuerung 4 von ihrem Potential getrennt und auf einheitliches Potential gelegt. Dadurch werden beide Steuerkanäle 16 der betreffenden Stellglieder 1 gleichzeitig durchlässig und bei laufender Zahnradpumpe 23 die Hydrozylinder 12 von der elektroviskosen Flüssigkeit mit hoher Geschwindigkeit durchströmt. Für die zyklische Durchspülung der Hydrozylinder 12 während längerer Betriebspausen kommt die Anlaufregimesteuerung 4 in gleicher Weise zum Einsatz, indem eine Zeitsteuerung das Anlaufregime simuliert.

Für das Anschlußschema der Elektroden ist es im wesentlichen unerheblich, welche der Elektroden 17 oder 18 auf dem höheren Potential liegt. Jedoch erweist es sich als günstig, das Potential an den ersten Elektroden 17 und den zweiten Elektroden 18 in bestimmten Zeiträumen (möglicherweise sogar zyklisch) zu tauschen, um Abscheidungen von Bestandteilen der elektroviskosen Flüssigkeit an den Elektrodenflächen zu vermeiden.
Zu dem in Fig. 2 dargestellten Anschlußschema ist noch anzumerken, daß lediglich die Mittelelektroden 19, die jeweils getrennt ansteuerbar sein müssen, durch das Reservoir 2 geführt werden. Die Sammelleitungen der ersten und zweiten Elektroden 17 und 18 können an beliebiger Stelle seitlich aus der Matrixanordnung herausgeführt werden. Die Darstellung von Fig. 2 ist insofern nicht repräsentativ für ihre Lage, da bei einer Verlegung durch das Reservoir 2 möglicherweise die Viskosität der Flüssigkeit unerwünscht beeinflußt werden könnte.
Die erfindungsgemäße Vorrichtung ist für verschiedene Anwendungen geeignet, die eine definierte, in einer Zeile oder Fläche erforderliche Höhenverstellung von punktuellen Stellgliedern 1 auf engstem Raum erfordern. Sie erweist sich vorrangig als geeignete Variante zur elektronischen Darstellung von Blindenschrift und entsprechenden Bildmatrixanzeigen, aber auch Zur Steuerung von Adaptern für Leiterplattentester.

## Patentansprüche

1. Vorrichtung zur Erzeugung von durch Höhenunterschiede charakterisierten Betriebszuständen mechanischer Stellglieder, die hydraulisch verstellbar sind, mit einer elektroviskosen Flüssigkeit betrieben werden und mit Elektroden versehene Steuerkanäle, die je nach anliegender Spannung das Strömen der Flüssigkeit zulassen oder unterbinden, aufweisen, dadurch gekennzeichnet, daß
- jedes Stellglied (1) einen Hydrozylinder (12) enthält, der über zwei Steuerkanäle (16) mit einem Reservoir (2) in Verbindung steht,
- sich das Reservoir (2) aus einer Überdruck-(22) und einer Unterdruckkammer (21) zusammensetzt,
- einer der Steuerkanäle (16) mit der Überdruckkammer (22) und der andere mit der Unterdruckkammer (21) verbunden ist und
- die Steuerkanäle (16) eines Stellgliedes (1) jeweils eine erste Elektrode (17) bzw. eine zweite Elektrode (18), die im Betriebszustand auf unterschiedliche Potentiale festgelegt sind, sowie eine gemeinsame Mittelelektrode (19) aufweisen, wobei die Mittelelektrode (19) die einzige Steuerelektrode eines jeden Stellgliedes (1) darstellt und im Umfang der Potentialdifferenz zwischen der ersten und zweiten Elektrode (17,18) umschaltbar ist, so daß der Durchfluß je nach Potentialunterschied in einem Steuerkanal (16) ermöglicht und im anderen behindert wird.

2. Vorrichtung nach Anspruch 1, dadurch gekennzeichnet,
daß jeder Hydrozylinder (12) aus einer Elastomermembran (13) besteht, die durch zylindrische Ausnehmungen in einer Abdeckplatte (14) nur in vertikaler Richtung dehnbar ist.

3. Vorrichtung nach Anspruch 1, dadurch gekennzeichnet,
daß alle Stellglieder (1) als zweidimensionale Matrix auf dem Reservoir (2), das zugleich deren einheitlichen Träger darstellt, angeordnet sind.

4. Vorrichtung nach Anspruch 1, dadurch gekennzeichnet,
daß Über- und Unterdruckkammer (21, 22) durch eine Pumpe, vorzugsweise eine Zahnradpumpe (23) ihr Druckgefälle erhalten.

5. Vorrichtung nach Anspruch 4, dadurch gekennzeichnet,
daß die Über- und die Unterdruckkammer (21, 22) des Reservoirs (2) jeweils über ein Gaspolster verfügen, das als Puffer zur Druckregelung dient.

6. Vorrichtung nach Anspruch 1, dadurch gekennzeichnet,
daß mehrere Stellglieder (1) zu einem Modul (3) zusammengefaßt sind.

7. Vorrichtung nach Anspruch 6, dadurch gekennzeichnet,
daß mindestens innerhalb eines Moduls (3) die ersten Elektroden (17) und die zweiten Elektroden (18) verschiedener Stellglieder (1) jeweils miteinander verbunden sind, wobei die eine Gruppe von Elektroden auf Bezugpotential und die andere Gruppe auf Betriebsspannung gelegt ist, und die Mittelelektrode (19) wahlweise auf eines der Potentiale der beiden Gruppen separat umschaltbar ist.

8. Vorrichtung nach Anspruch 6, dadurch gekennzeichnet,
daß sämtliche Elektroden (17,18,19) von Stellgliedern (1) über eine Anlaufregimesteuerung (4) geführt sind, die neben der Einstellung des notwendigen Druckgefälles zwischen Überdruck- (21) und Unterdruckkammer (22) gewährleistet, daß alle Elektroden (17,18,19) mindestens modulweise auf gleiches Potential umschaltbar sind zum Durchspülen der betreffenden Hydrozylinder (12) in einer Anlaufphase.

9. Vorrichtung nach Anspruch 8, dadurch gekennzeichnet,
daß die Anlaufregimesteuereinheit (4) auch während längerer Betriebspausen zyklisch zuschaltbar ist, um Entmischungsvorgängen der elektroviskosen Flüssigkeit entgegenzuwirken.
